# EUROPÄISCHE PATENTANMELDUNG

(11) **EP 4 098 782 A1**
(43) Veröffentlichungstag der Anmeldung: **07.12.2022**
(21) Anmeldenummer: 21177025.0
(22) Anmeldetag: 01.06.2021
(51) Int. Cl.: C30B 25/12, C23C 16/458, C23C 16/52, C30B 25/16, H01L 21/67, C30B 25/10

(54) **VERFAHREN ZUM ABSCHEIDEN EINER EPITAKTISCHEN SCHICHT AUF EINER SUBSTRATSCHEIBE AUS HALBLEITERMATERIAL IN EINER ABSCHEIDEVORRICHTUNG**

(71) Anmelder: Siltronic AG, 81677 München (DE)
(72) Erfinder: Stettner, Thomas, 83329 Waging am See (DE); Edmaier, Walter, 84384 Wittibreut (DE)
(74) Vertreter: Staudacher, Wolfgang

(57) **Zusammenfassung**

Verfahren zum Abscheiden einer epitaktischen Schicht auf einer Substratscheibe aus Halbleitermaterial in einer Abscheidevorrichtung, umfassend
das Ablegen der Substratscheibe auf einem Suszeptor der Abscheidevorrichtung, der durch einen Spalt getrennt von einem Vorheizring umgeben ist und von einer Tragwelle gehalten wird;
das Bestimmen einer Exzentrizität zwischen einer Achse senkrecht durch die Mitte des Vorheizrings und einer Achse senkrecht durch die Mitte des Suszeptors;
das Leiten von Abscheidegas über die Substratscheibe entlang einer von einem Gaseinlass zu einem Gasauslass weisenden Strömungsrichtung;
das Leiten von Spülgas entlang einer unteren Seite eines Vorheizrings und einer unteren Seite des Suszeptors;
das Drehen der Tragwelle um eine Drehachse mit einer Frequenz;
gekennzeichnet durch
das Verschieben der Tragwelle von einer Ausgangsposition, in der deren Drehachse entlang der Achse senkrecht durch die Mitte des Vorheizrings angeordnet ist, bis zu einer Endposition und zurück zur Ausgangsposition mit der Frequenz des Drehens der Tragwelle, wobei der Verschiebeweg von der Ausgangsposition bis zur Endposition von der Exzentrizität abhängt.

## Beschreibung

Gegenstand der Erfindung ist ein Verfahren zum Abscheiden einer epitaktischen Schicht auf einer Substratscheibe aus Halbleitermaterial in einer Abscheidevorrichtung.

### Stand der Technik / Probleme

Das Abscheiden einer epitaktischen Schicht auf einer Substratscheibe aus Halbleitermaterial erfolgt üblicherweise mittels CVD (chemical vapor deposition) in einer Abscheidevorrichtung, die eine Substratscheibe aufnehmen kann. Während des Abscheidens der epitaktischen Schicht liegt die Substratscheibe auf einem Suszeptor, der von einer Tragwelle gehalten und gedreht wird, wobei ein Abscheidegas über eine freie obere Fläche der Substratscheibe, also deren Vorderseite, geleitet wird, und gleichzeitig ein Spülgas entlang einer unteren Seite eines Vorheizrings und einer unteren Seite des Suszeptors. Der Vorheizring ist durch einen Spalt getrennt um den Suszeptor herum angeordnet. Eine obere und eine untere Kuppel (upper dome, lower dome) definieren einen Reaktionsraum, innerhalb dessen die epitaktische Schicht auf der Substratscheibe abgeschieden wird. Strahlungswärme von Lampenbänken wird durch eine oder beide Kuppeln eingestrahlt, um eine notwendige Abscheidetemperatur bereitzustellen.

Eine Abscheidevorrichtung mit diesen Merkmalen ist beispielsweise in US 2016 0 010 239 A1 beschrieben.

Halbleiterscheiben mit einer epitaktischen Schicht (epitaxial wafer) werden für besonders anspruchsvolle Anwendungen in der elektronischen Industrie benötigt. Dementsprechend sind die Anforderungen beispielsweise bezüglich der Gleichmäßigkeit der Dicke der abgeschiedenen epitaktischen Schicht besonders herausfordernd.

DE 11 2018 001 223 T5 offenbart, dass Dickenunterschiede in der epitaktischen Schicht mittels eines Vorheizrings, dessen Form des inneren Umfangs von einer Kreisform abweicht, verringert werden können, falls die Ursache der Dickenunterschiede eine kaum vermeidbare nicht zentrische Lage des Suszeptors während des Abscheidens der epitaktischen Schicht ist. Die nicht zentrische Lage äußert sich in einer Exzentrizität zwischen einer Achse senkrecht durch die Mitte der des Vorheizrings und einer Achse senkrecht durch die Mitte der Substratscheibe.

In JP2016213242 A2 wird demselben Problem mit einer Anpassung der Bedingungen begegnet, unter denen die epitaktische Schicht wächst. Die Anpassung erfolgt in Abhängigkeit der Exzentrizität, die mittels eines Kamerasystems ermittelt wird.

Nachteilig an diesen Lösungen ist, dass die Form des Vorheizrings ein statisches System darstellt, mit dem auf wechselnde Exzentrizitäten nicht ohne Weiteres reagiert werden kann. Das Anpassen von Wachstumsbedingungen ist problematisch, weil damit in die Strömungsmechanik eines komplexen Systems eingegriffen werden muss, das insbesondere im Hinblick auf die Verteilung von Dotierstoffen empfindlich reagiert.

Es ist deswegen wünschenswert, eine einfach umzusetzende Lösung bereitzustellen, die solche Nachteile nicht hat.

Die Aufgabe der Erfindung wird gelöst durch ein Verfahren zum Abscheiden einer epitaktischen Schicht auf einer Substratscheibe aus Halbleitermaterial in einer Abscheidevorrichtung, umfassend
das Ablegen der Substratscheibe auf einem Suszeptor der Abscheidevorrichtung, der durch einen Spalt getrennt von einem Vorheizring umgeben ist und von einer Tragwelle gehalten wird;
das Bestimmen einer Exzentrizität zwischen einer Achse senkrecht durch die Mitte des Vorheizrings und einer Achse senkrecht durch die Mitte des Suszeptors;
das Leiten von Abscheidegas über die Substratscheibe entlang einer von einem Gaseinlass zu einem Gasauslass weisenden Strömungsrichtung;
das Leiten von Spülgas entlang einer unteren Seite eines Vorheizrings und einer unteren Seite des Suszeptors;
das Drehen der Tragwelle um eine Drehachse mit einer Frequenz;
gekennzeichnet durch
das Verschieben der Tragwelle von einer Ausgangsposition, in der deren Drehachse entlang der Achse senkrecht durch die Mitte des Vorheizrings angeordnet ist, bis zu einer Endposition und zurück zur Ausgangsposition mit der Frequenz des Drehens der Tragwelle, wobei der Verschiebeweg von der Ausgangsposition bis zur Endposition von der Exzentrizität abhängt.

Das Verfahren kann auch im heißen Zustand der Abscheidekammer, beispielsweise bei Abscheidetemperatur durchgeführt werden, weil ein Öffnen der Abscheidekammer nicht erforderlich ist.

Die Exzentrizität wird vorzugsweise mittels eines Kamerasystems bestimmt, mit dem an mindestens einer Position die Änderung der Breite des Spalts zwischen dem inneren Rand des Vorheizrings und dem äußeren Rand des Suszeptors ermittelt und daraus die Exzentrizität berechnet wird. Beispielsweise kann bei vorgegebener Drehgeschwindigkeit des Suszeptors der Drehwinkel gemessen werden, zu dem die größte Breite des Spalts seit dem Beginn einer Umdrehung beobachtet wird, wobei den Beginn einer Umdrehung ein Homesignal der Abscheidevorrichtung festgelegt.

Der Suszeptor liegt mit Aufnahmeflächen auf Halteflächen von Armen der Tragwelle auf. Die Exzentrizität ist insbesondere durch Fertigungstoleranzen bedingt, die die Halteflächen auf den Armen der Tragwelle einerseits und die Aufnahmeflächen auf dem Suszeptor andererseits in Anspruch nehmen.

Entsprechend dem Betrag der Exzentrizität ist der Spalt zwischen dem inneren Rand des Vorheizrings und dem äußeren Rand des Suszeptors an einer Position des Umfangs des Suszeptors breiter als an den übrigen Positionen. Wegen des breiteren Spalts gelangt mehr an Spülgas in den Reaktionsraum über der Substratscheibe, wo es das Abscheidegas stärker verdünnt. Dieser Effekt sorgt für eine ungleichmäßigere Verteilung der Schichtdicke der auf der Substratscheibe abgeschiedenen epitaktischen Schicht.

Erfindungsgemäß wird die Tragwelle des Suszeptors mit der Frequenz des Drehens der Tragwelle von einer Ausgangsposition, in der sie entlang der Achse senkrecht durch die Mitte des Vorheizrings angeordnet ist, bis zu einer Endposition und zurück zur Ausgangsposition verschoben, wobei der Verschiebeweg von der Ausgangsposition bis zur Endposition von der Exzentrizität zwischen der Achse senkrecht durch die Mitte des Vorheizrings und der Achse senkrecht durch die Mitte des Suszeptors abhängt.

Zum Verschieben der Tragwelle kann beispielsweise ein Antrieb verwendet werden, der in US 2016 0 010 239 A1 beschrieben ist. Vorzugsweise wird die Tragwelle mittels mindestens eines Aktuators piezoelektrisch verschoben.

Der Suszeptor wird vorzugsweise mit 30 Umin⁻¹ bis 60 Umin⁻¹ gedreht, und die Tragwelle dementsprechend mit einer Periodendauer von 1 s bis 2 s verschoben.

Die Substratscheibe besteht aus Halbleitermaterial, vorzugsweise aus einkristallinem Silizium, ebenso wie die epitaktische Schicht, die auf der Vorderseite der Substratscheibe abgeschieden wird. Der Durchmesser der Substratscheibe beträgt vorzugsweise mindestens 200 mm, besonders bevorzugt mindestens 300 mm.

Das Abscheidegas enthält eine das Halbleitermaterial enthaltende Verbindung, beispielsweise Silan oder ein Chlorsilan, beispielsweise Trichlorsilan, das Spülgas vorzugsweise Wasserstoff.

Gemäß einer ersten Ausgestaltung der Erfindung wird der Verschiebeweg von der Ausgangsposition bis zur Endposition von einem Vektor beschrieben, dessen Betrag dem Betrag der Exzentrizität entspricht und dessen Richtung der Richtung der Exzentrizität entgegengerichtet ist. Betrag und Richtung des Verschiebens der Tragwelle orientieren sich also an der Exzentrizität zwischen der Achse senkrecht durch die Mitte des Vorheizrings und der Achse senkrecht durch die Mitte des Suszeptors. Mit der Frequenz der Drehbewegung der Tragwelle wird die Tragwelle von einer Ausgangsposition bis zu einer Endposition und zurück zur Ausgangsposition verschoben. In der Ausgangsposition ist die Tragwelle des Suszeptors entlang der Achse senkrecht durch die Mitte des Vorheizrings angeordnet.

Üblicherweise ist diese Achse auch die Achse senkrecht durch die Mitte der Abscheidevorrichtung.

Durch das Verschieben der Tragwelle und des von ihr gehaltenen Suszeptors, wird die wegen der Exzentrizität vorhandene Unwucht der Drehbewegung des Suszeptors abgemildert. Die auf dem Suszeptor liegende Substratscheibe liegt im zeitlichen Mittel zentrischer zum Vorheizring, und damit ist die Breite des Spalts zwischen dem Vorheizring und dem Suszeptor im zeitlichen Mittel einheitlicher. Das wirkt sich auf die Dicke der auf der Substratscheibe abgeschiedenen epitaktischen Schicht aus, deren Verteilung einheitlicher wird.

Gemäß einer zweiten Ausgestaltung der Erfindung wird eine Keiligkeit der Substratscheibe bestimmt und beim Verschieben der Tragwelle des Suszeptors mitberücksichtigt.

Eine Substratscheibe ist keilig, wenn ihre Dicke beim Betrachten des Querschnitts der Substratscheibe entlang ihres Durchmessers linear zunimmt oder linear abnimmt. Die Keiligkeit kann beispielsweise durch das Verhältnis von größter und kleinster Querschnittsdicke quantifiziert werden.

Die Erfinder haben festgestellt, dass die Keiligkeit mit dem Abscheiden der epitaktischen Schicht abnimmt, wenn die Tragwelle des Suszeptors während des Abscheidens von einer Ausgangsposition zu einer Endposition mit der Frequenz der Drehung der Tragwelle des Suszeptors entlang der Strömungsrichtung des Abscheidegases hin und her verschoben wird. In der Ausgangsposition ist die Tragwelle des Suszeptors entlang der Achse senkrecht durch die Mitte des Vorheizrings angeordnet. Der Betrag des Verschiebewegs von der Ausgangsposition zur Endposition richtet sich nach dem Ausmaß der Keiligkeit der Substratscheibe. Die Korrelation von Betrag an Verschiebeweg, der beim Vorliegen einer bestimmten Keiligkeit der Substratscheibe erforderlich ist, um die Keiligkeit durch das Abscheiden der epitaktischen Schicht weitgehend zu beseitigen, muss vorab experimentell bestimmt werden. Betrag und Richtung dieses Verschiebewegs können also durch einen von der Keiligkeit der Substratscheibe abhängigen weiteren Vektor beschrieben werden.

Die zweite Ausgestaltung der Erfindung sieht vor, die Keiligkeit der Substratscheibe und die Exzentrizität zwischen der Achse senkrecht durch die Mitte des Vorheizrings und der Achse senkrecht durch die Mitte des Suszeptors zu berücksichtigen.

Dementsprechend wird die Tragwelle des Suszeptors während des Abscheidens der epitaktischen Schicht mit der Frequenz der Drehung der Tragwelle entsprechend der Vorgabe eines resultierenden Vektors von der Ausgangsposition zur Endposition und zurück zur Ausgangsposition verschoben. In der Ausgangsposition ist die Tragwelle des Suszeptors entlang der Achse senkrecht durch die Mitte des Vorheizrings angeordnet. Der resultierende Vektor entspricht der Vektorsumme des weiteren Vektors, der den von der Keiligkeit der Substratscheibe abhängenden Verschiebeweg beschreibt und des Vektors, der den Verschiebeweg beschreibt, der von der Exzentrizität zwischen der Achse senkrecht durch die Mitte des Vorheizrings und der Achse senkrecht durch die Mitte des Suszeptors abhängt.

Die Erfindung wird nachfolgend unter Bezugnahme auf Zeichnungen weiter vorgestellt. Im Folgenden wird davon ausgegangen, dass die Substratscheibe zentrisch auf dem Suszeptor liegt und die Exzentrizität wegen einer nicht zentrischen Lage des Suszeptors auf den Tragarmen der Tragwelle des Suszeptors besteht.

### Kurzbeschreibung der Figuren

**Fig.** 1 zeigt eine Vorrichtung in Schnittdarstellung, die zur Durchführung des erfindungsgemäßen Verfahrens geeignet ist.
**Fig.** 2 zeigt weitere Einzelheiten der Vorrichtung.
**Fig. 3** und **Fig.4** zeigen in Draufsicht die relative Lage von Suszeptor und Vorheizring bei einer bestehenden Exzentrizität zwischen der Achse senkrecht durch die Mitte des Vorheizrings und einer Achse senkrecht durch die Mitte des Suszeptors, und das Verschieben der Tragwelle gemäß der ersten und der zweiten Ausgestaltung der Erfindung.

### Liste der verwendeten Bezugszeichen

**1** Substratscheibe
**2** Suszeptor
**3** Vorheizring
**4** Ablagefläche
**5** Spalt
**6** Bildausschnitt
**7** Kamerasystem
**8** Bildverarbeitung
**9** Tragwelle
**10** Tragarme
**11** Hebewelle
**12** Basis
**13** Gaseinlass
**14** Gasauslass
**15** weiterer Gaseinlass
**16** weiterer Gasauslass
**17** obere Kuppel
**18** untere Kuppel
**19** Lampenbänke
**20** Abscheidevorrichtung
**21** Steuerungseinrichtung
**22** Achse senkrecht durch die Mitte des Vorheizrings
**23** Rückseite
**24** Boden
**25** Faltenbalg
**26** Achse senkrecht durch die Mitte des Suszeptors
**27** Aktuator
**28** Aktuator
**29** Aktuator
**30** Aktuator

### Detaillierte Beschreibung erfindungsgemäßer Ausführungsbeispiele

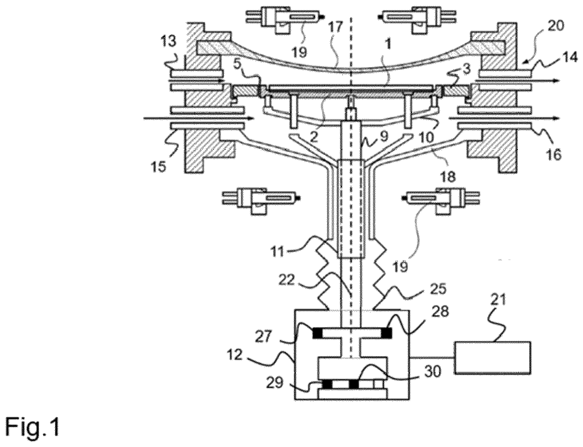

Fig.1 zeigt in Schnittdarstellung eine Vorrichtung zum Abscheiden einer epitaktischen Schicht auf einer Substratscheibe aus Halbleitermaterial, die zur Durchführung des erfindungsgemäßen Verfahrens geeignet ist. Der Reaktionsraum dieser Abscheidevorrichtung 20 ist nach oben durch eine obere Kuppel 17 und nach unten durch eine untere Kuppel 18 begrenzt. In der Mitte des Reaktionsraums ist eine Tragwelle 9 angeordnet, von der an einem oberen Ende Tragarme 10 abzweigen. Die Tragarme 10 stützen einen Suszeptor 2, auf dem während des Abscheidens einer epitaktischen Schicht eine Substratscheibe 1 liegt. Bei der gezeigten Ausführungsform ist vorgesehen, die Substratscheibe 1 im Zuge des Beladens der Abscheidevorrichtung 20 auf einer Hebewelle 11 abzulegen und durch Absenken der Hebewelle 11 auf dem Suszeptor 2 abzulegen. Zwischen der Seitenwand der Abscheidevorrichtung und dem Suszeptor 2 ist ein Vorheizring 3 angeordnet. Das Abscheidegas wird über eine zur oberen Kuppel 17 zeigende Vorderseite der Substratscheibe 1 von einem Gaseinlass 13 zu einem Gasauslass 14 geleitet, die an einer Seitenwand der Abscheidevorrichtung angeordnet sind. Des Weiteren ist auch ein entsprechender weiterer Gaseinlass 15 und weiterer Gasauslass 16 für Spülgas vorgesehen, das unter dem Vorheizring 3 und unter dem Suszeptor 2 durch den Reaktionsraum geleitet wird. Pfeile deuten die Fließrichtung der Gasflüsse an. Abhängig von der Breite eines Spalts 5 zwischen dem Vorheizring 3 und dem Suszeptor 2 gelangt ein Teil des Spülgases in den Strom des Abscheidegases und verdünnt das Abscheidegas. Von außen wird der Reaktionsraum durch Lampenbänke 19 beheizt, die Strahlungsenergie durch die obere und untere Kuppel 17 und 18 einstrahlen. Die untere Kuppel 18 der Abscheidevorrichtung 20 ist mit der Basis 12 durch einen Faltenbalg 25 verbunden, um das Bewegen der Tragwelle 9 zu ermöglichen und um den durch ihn geschaffenen Innenraum gegen einströmende Umgebungsatmosphäre abzudichten.

Die Vorrichtung umfasst eine Steuerungseinrichtung 21, die konfiguriert ist, die Tragwelle 9 periodisch zu verschieben. Zum Verschieben der Tragwelle 9 in der Horizontalen sind Aktuatoren 27 (zum Verschieben in x-Richtung) und 28 (zum Verschieben in y-Richtung) vorgesehen. Gegebenenfalls können auch weitere Aktuatoren 29 und 30 zum Kippen der Tragwelle 9 aus der Ansichtsebene von Fig.1 heraus vorgesehen sein.

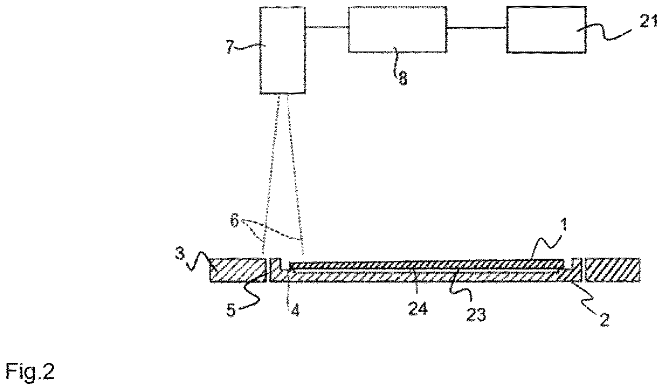

Des Weiteren umfasst die Vorrichtung ein Kamerasystem 7 mit Bildverarbeitung 8 (Fig. 2), um eine Exzentrizität zwischen der Achse 22 senkrecht durch die Mitte des Vorheizrings 3 und einer Achse 26 senkrecht durch die Mitte des Suszeptors 2 zu bestimmen. Das Kamerasystem 7 umfasst eine Kamera zum Beobachten eines Bildausschnitts 6 während des Drehens des Suszeptors 2 mittels der Tragwelle 9. Der Bildausschnitt 6 erfasst einen sich radial erstreckenden Bereich, der vorzugsweise einen Abschnitt des äußeren Umfangs der Substratscheibe 1, einen Abschnitt des äußeren Umfangs des Suszeptors 2, und einen Abschnitt des inneren Umfangs des Vorheizrings 3 einschließt und damit auch einen Abschnitt des Spalts 5 zwischen dem Suszeptor 2 und dem Vorheizring 3. Die Substratscheibe 1 liegt in einer Vertiefung (pocket) des Suszeptors 2 auf einer Ablagefläche 4, so dass die Rückseite 23 der Substratscheibe 1 Abstand zum Boden 24 des Suszeptors 2 hat. Die im Bildausschnitt 6 enthaltenen Informationen werden mittels der Bildverarbeitung 8 ausgewertet.

Die in Fig. 2 dargestellte Substratscheibe 1 hat einen keiligen Querschnitt. Ihre Dicke nimmt von einem dünneren Rand zu einem dickeren Rand linear zu.

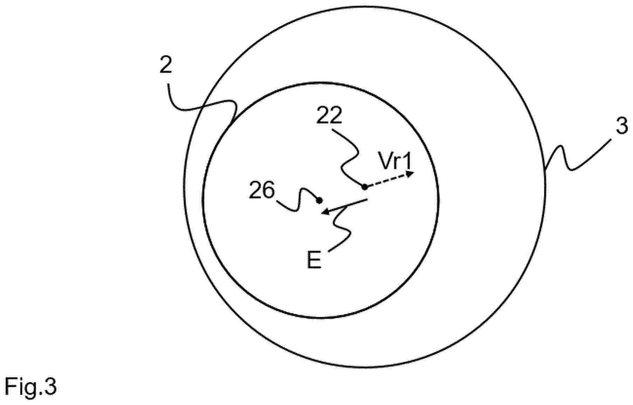

Fig. 3 zeigt in Draufsicht die relative Lage des Suszeptors 2 und des inneren Rands des Vorheizrings 3 bei einer bestehenden Exzentrizität zwischen der Achse 22 senkrecht durch die Mitte des Vorheizrings 3 und der Achse 26 senkrecht durch die Mitte des Suszeptors 2. Die Drehachse der Tragwelle 9 ist in dieser Ausgangsposition entlang der Achse 22 senkrecht durch die Mitte des Vorheizrings 3 angeordnet. Betrag und Richtung der Exzentrizität beschreibt der Vektor E. Liegt die Substratscheibe 1 zentrisch auf dem Suszeptor 2 haben die Achse 26 senkrecht durch die Mitte des Suszeptors und die Achse senkrecht durch die Mitte der Substratscheibe dieselbe Lage. Gemäß der ersten Ausgestaltung der Erfindung wird die Tragwelle 9 während des Abscheidens einer epitaktischen Schicht auf der Substratscheibe 1 mit einer Frequenz gedreht und während einer jeden Drehung von der Ausgangsposition zu einer Endposition und zurück zur Ausgangsposition verschoben. Betrag und Richtung der Verschiebung beschreibt der Vektor Vr1, dessen Betrag dem Betrag des Vektors E entspricht und dessen Richtung derjenigen des Vektors E entgegengerichtet ist. In der Ausgangsposition ist die Drehachse der Tragwelle 9 entlang der Achse 22 senkrecht durch die Mitte des Vorheizrings 3 ausgerichtet und in der Endposition zur Spitze des Vektors Vr1 verschoben.

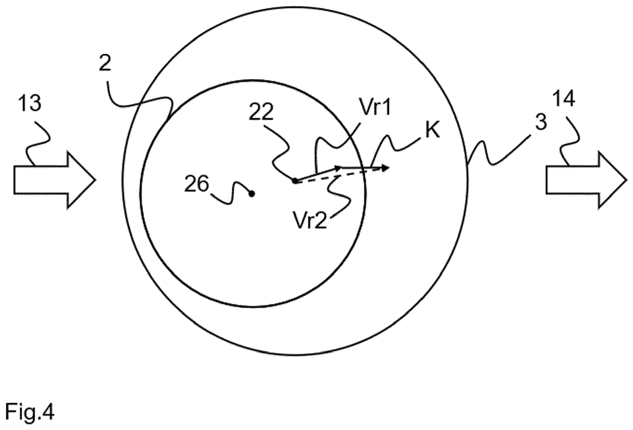

Gemäß der zweiten Ausgestaltung der Erfindung wird die Keiligkeit der Substratscheibe beim Verschieben der Tragwelle des Suszeptors mitberücksichtigt. Fig.4 ist eine Darstellung wie die von Fig.3 und verdeutlicht die zweite Ausgestaltung. Gemäß der zweiten Ausgestaltung der Erfindung wird die Tragwelle 9 des Suszeptors 2 während des Abscheidens einer epitaktischen Schicht auf der Substratscheibe 1 mit einer Frequenz gedreht und während einer jeden Drehung von der Ausgangsposition zu einer Endposition und zurück zur Ausgangsposition verschoben. Betrag und Richtung des Verschiebewegs von der Ausgangsposition zur Endposition beschreibt der resultierende Vektor Vr2. Dieser Vektor entspricht der Summe der Vektoren Vr1 und K, wobei der Vektor K eine Richtung vom Gaseinlass 13 von Abscheidegas zum Gasaulass 14 hat, also die Strömungsrichtung des Abscheidegases, und einen Betrag, der von der Keiligkeit der Substratscheibe 1 abhängt. In der Ausgangsposition ist die Drehachse der Tragwelle 9 entlang der Achse 22 senkrecht durch die Mitte des Vorheizrings 3 ausgerichtet und in der Endposition zur Spitze des resultierenden Vektors Vr2 verschoben.

Die Längen der in Fig.3 und Fig.4 dargestellten Vektoren sind zur Verdeutlichung übertrieben gezeichnet. Tatsächlich beträgt der jeweilige Verschiebeweg typischerweise 100 - 1000 µm.

## Patentansprüche

1. Verfahren zum Abscheiden einer epitaktischen Schicht auf einer Substratscheibe aus Halbleitermaterial in einer Abscheidevorrichtung, umfassend das Ablegen der Substratscheibe auf einem Suszeptor der Abscheidevorrichtung, der durch einen Spalt getrennt von einem Vorheizring umgeben ist und von einer Tragwelle gehalten wird;
das Bestimmen einer Exzentrizität zwischen einer Achse senkrecht durch die Mitte des Vorheizrings und einer Achse senkrecht durch die Mitte des Suszeptors;
das Leiten von Abscheidegas über die Substratscheibe entlang einer von einem Gaseinlass zu einem Gasauslass weisenden Strömungsrichtung;
das Leiten von Spülgas entlang einer unteren Seite eines Vorheizrings und einer unteren Seite des Suszeptors;
das Drehen der Tragwelle um eine Drehachse mit einer Frequenz;
**gekennzeichnet durch**
das Verschieben der Tragwelle von einer Ausgangsposition, in der deren Drehachse entlang der Achse senkrecht durch die Mitte des Vorheizrings angeordnet ist, bis zu einer Endposition und zurück zur Ausgangsposition mit der Frequenz des Drehens der Tragwelle, wobei der Verschiebeweg von der Ausgangsposition bis zur Endposition von der Exzentrizität abhängt.

2. Verfahren nach Anspruch 1, **dadurch gekennzeichnet, dass** der Verschiebeweg von der Ausgangsposition bis zur Endposition einem Vektor beschrieben wird, dessen Betrag dem Betrag der Exzentrizität entspricht und dessen Richtung der Richtung der Exzentrizität entgegengerichtet ist.

3. Verfahren nach Anspruch 2, **dadurch gekennzeichnet, dass** der Verschiebeweg von der Ausgangsposition bis zur Endposition von einem resultierenden Vektor einer Vektorsumme beschrieben wird mit dem Vektor und einem weiteren Vektor als Summanden, wobei der Betrag des weiteren Vektors von einer Keiligkeit der Substratscheibe abhängt und die Richtung des weiteren Vektors die Strömungsrichtung des Abscheidegases hat.

4. Verfahren nach einem der Ansprüche 1 bis 3, **gekennzeichnet durch** das Verschieben der Tragwelle mittels mindestens eines Aktuators.
